# EUROPEAN PATENT APPLICATION

(11) **EP 1 507 025 A1**
(43) Date of publication of application: **16.02.2005**
(21) Application number: 03715705.4
(22) Date of filing: 01.04.2003
(51) Int. Cl.: C23C 14/56, G11B 7/26, H01L 21/68

(54) **DEVICE AND METHOD FOR FORMING THIN-FILM, AND METHOD OF MANUFACTURING ELECTRONIC COMPONENT USING THE DEVICE**

(30) Priority: 09.04.2002 JP 2002106423
(71) Applicant: TDK Corporation, Chuo-ku, Tokyo 103-8272 (JP)
(72) Inventor: KOSHIKAWA, Masato, c/o TDK Corporation, Chuo-ku, Tokyo 103-8272 (JP); MATSUI, Satoshi, c/o TDK Corporation, Chuo-ku, Tokyo 103-8272 (JP)
(74) Representative: Grünecker, Kinkeldey, Stockmair & Schwanhäusser Anwaltssozietät
(86) International application number: PCT/JP2003/004171
(87) International publication number: WO 2003/085160

(57) **Abstract**

A film formation apparatus is structured such that vacuum chambers each having a plurality of film forming chambers are arranged in planes different from each other and allowed to communicate with each other through a delivery chamber with the vacuum chamber kept in vacuum, and a substrate is transferred between the vacuum chambers by a substrate delivery mechanism arranged in the delivery chambers. The structure is thus adopted, whereby the number of chambers in the film formation apparatus can be easily increased, an installation space can be reduced, and a production efficiency can be increased.

## Description

### TECHNICAL FIELD

The present invention relates to a thin film formation apparatus for forming a thin film on a substrate. In particular, the present invention relates to an apparatus structure of a thin film formation apparatus having plural thin film formation chambers, that is, film formation chambers, and to a thin film formation method using the apparatus. The present invention also relates to an electronic part manufacturing method for manufacturing a thin-film electronic part such as a magnetic head or magnetic recording medium using the apparatus.

### BACKGROUND ART

In general, a thin film is formed in a vacuum chamber. Thus, in forming the thin film, a series of steps of carrying a substrate into the vacuum chamber, evacuating the vacuum chamber, starting thin film formation after reducing an internal pressure of the vacuum chamber down to a predetermined pressure, making the vacuum chamber open to the air after the thin film formation, and taking out the substrate is necessary. Hence, in the case where plural kinds of thin films need to be formed and the respective thin films are formed with separate apparatuses, the steps of evacuating the vacuum chamber and making the chamber open to the air or other such steps that do not actually contribute to the film formation take more time, leading to a decreased production efficiency.

To that end, a widely used apparatus is structured such that portions used for carrying in or taking out the substrate are only made open to the air, and a substrate is transferred to plural chambers one after another, which are kept under vacuum all the time to thereby form thin films. More specifically, a so-called multi-chamber type apparatus is employed, in which a substrate conveying apparatus for holding and conveying a substrate etc. is disposed at its central portion, and film formation chambers, and a substrate feeding and take-out chamber are almost radially arranged so as to surround the apparatus.

In the above apparatus, the plural film formation chambers and substrate feeding and take-out chamber arranged in a circle have carrier holders arranged almost radially in a one-to-one correspondence, and drive units for driving the carrier holders. The substrate held by the carrier holder in the substrate feeding and take-out chamber is conveyed together with the carrier holder by the carrier holder drive unit to its adjacent film formation chamber where predetermined film formation is effected. Upon completion of the predetermined film formation, the substrate is conveyed together with the carrier holder to its adjacent film formation chamber where the next film formation is effected. In subsequent processes, thin films are formed one after another on the substrate in each film formation chamber.

Some kinds of thin films may require a long time to form, for example, it takes much time to form a thin film into a relatively large thickness or to form a thin film at a low film formation rate. In this case, the following structure is proposed: the same thin film is formed in plural film formation chambers to thereby share time properly between the time for forming a thin film to a relatively small thickness and the time for forming a thin film to a relatively large thickness, or between the time for forming a thin film at a low film formation rate and the time for forming a thin film at a high film formation rate, with the result that a production efficiency is kept from lowering.

Also, in such a structure, the substrate is continuously exposed to a plasma and thus easily increases its temperature due to radiation heat etc. from the plasma. As a result, if the substrate is low in heat resistance, it is necessary to temporarily suspend the film formation such as stopping discharge during the film formation to thereby cool the substrate. At this time, taken as a measure for keeping a production efficiency from lowering is a structure in which some of the film formation chambers are used exclusively for cooling, where the substrate is not exposed to a plasma.

As an example of an electronic part obtained by forming plural thin films on a substrate, there is a recording medium, a so-called optical disk such as DVD-R of double-layer structure. The optical disk is structured by stacking plural layers such as a reflective layer, a recording layer, and a protective layer on a substrate. In an actual manufacturing process, the aforementioned films are successively stacked in the respective film formation chambers by a technique called sputtering, on a substrate made of a resin such as polycarbonate. In the film structure, for example, the protective layer is formed from an oxide film to be formed at a relatively low film formation rate. In addition, the protective layer should be formed with a large thickness. For that purpose, the protective layer is formed with the plural film formation chambers.

As discussed above, the more the kinds of thin films to be formed or the larger the thickness of the oxide film or the like to be formed, the larger the number of film formation chambers. However, according as the number of film formation chambers increases, an outer size of an entire apparatus expands as well as the length of the carrier holder extending from its central portion to each film formation chamber increases. This means the increase in weight of the carrier holder. It is therefore difficult to meet conditions required of a carrier holder drive mechanism to a satisfactory level, such as a torque or stop position accuracy, which raises a fear that the apparatus itself is hard to construct. However, in the manufacturing process for the DVD-R etc., the requisite number of film formation chambers is expected to increase more and more in the future.

In the present situation, feeding and taking-out the substrate are carried out in a single chamber and the remaining chambers are all used as film formation chambers. Hence, a requisite number of film formation chambers are provided without increasing the total number of chambers. However, it is basically preferred to use separate chambers for feeding the substrate and for taking out the substrate. Taking into consideration a heat resistance of the substrate, a chamber for cooling the substrate is preferably provided downstream of plural film formation chambers if possible.

### DISCLOSURE OF THE INVENTION

The present invention has been made in view of the above circumstances, and has an object to allow an easy increase in the number of chambers in a film formation apparatus and to provide a film formation apparatus increasing its production efficiency.

In order to solve the above problem, according to the present invention, a thin film formation apparatus for forming a thin film on a surface of a substrate includes: a plurality of vacuum chambers each having a plurality of thin film formation chambers and a conveying system for holding the substrate and conveying the substrate between the thin film formation chambers, the vacuum chambers being arranged in planes different from each other; and a substrate delivery mechanism for transferring the substrate to the conveying systems between the plurality of vacuum chambers, and is characterized in that the substrate delivery mechanism is placed in a delivery chamber for communicating the plurality of vacuum chambers with each other.

Further, in order to solve the above problem, according to the present invention, a thin film formation apparatus for forming a thin film on a surface of a substrate includes: thin film formation chambers; a substrate feeding chamber; a substrate delivery chamber, the thin film formation chambers, the substrate feeding chamber, and the substrate delivery chamber being arranged substantially in a circle; and a plurality of substrate holding means arranged almost radially toward each of the chambers and rotatably around a center of a radial pattern, in each of a plurality of planes, and is characterized in that the substrate delivery chambers each arranged in each of the plurality of planes communicate with each other and the substrate is transferred between the substrate holding means in different planes in the substrate delivery chambers.

Note that in the above thin film formation apparatus, the substrate is preferably integrated with a mask covering a part of the surface of the substrate and held by the conveying system. Further, the thin film formation apparatus preferably includes a processing chamber for effecting a process other than thin film formation on the substrate.

Further, in order to solve the above problem, according to the present invention, a thin film formation method for forming a thin film on a substrate is characterized by including: feeding and holding the substrate to a conveying system capable of transferring the substrate to a film formation chamber group formed on the same plane; transferring the substrate to the film formation chamber group arranged on the plane by the conveying system and passing the substrate sequentially through film formation chambers of the film formation chamber group to form the thin film on the substrate; feeding and holding the substrate to another conveying system capable of transferring the substrate to another film formation chamber group formed on another plane different from the plane through a substrate delivery mechanism provided within a vacuum chamber continuous to the film formation chamber; and transferring the substrate to the other film formation chamber group arranged on the other plane by the other conveying system and sequentially passing the substrate through film formation chambers of the other film formation chamber group to form another thin film on the substrate.

Note that in the above method, the substrate is preferably integrated with a mask covering a part of the surface of the substrate and held by the conveying system, the other conveying system, and the substrate delivery mechanism. Further, it is preferable that the film formation chamber group and the other film formation chamber group include a processing chamber not involved in film formation, and the substrate pass through the processing chamber while being conveyed.

Further, in order to solve the above problem, according to the present invention, an electronic part manufacturing method for forming a thin film on a predetermined surface of an electronic part is characterized by including: feeding and holding the electronic part to a conveying system capable of transferring the electronic part to a film formation chamber group formed on the same plane; transferring the electronic part to the film formation chamber group arranged on the plane by the conveying system and passing the electronic part sequentially through film formation chambers of the film formation chamber group to form the thin film on the predetermined surface of the electronic part; feeding and holding the electronic part to another conveying system capable of transferring the electronic part to another film formation chamber group formed on another plane different from the plane through an electronic part delivery mechanism provided within a vacuum chamber continuous to the film formation chamber; and transferring the electronic part to the other film formation chamber group arranged on the other plane by the other conveying system and sequentially passing the electronic part through film formation chambers of the other film formation chamber group to form another thin film on the predetermined surface of the electronic part.

### BRIEF DESCRIPTION OF THE DRAWINGS

Fig. 1A is a longitudinal sectional view of a film formation apparatus according to the present invention;
Fig. 1B shows the film formation apparatus according to the present invention and is a cross-sectional view of a substrate delivery chamber;
Fig. 1C shows the film formation apparatus according to the present invention and is a cross-sectional view of the substrate delivery chamber;
Fig. 2 is an enlarged view of a substrate delivery mechanism (portion "A" in the figure) of Fig. 1A;
Fig. 3A is a schematic plan view of a first vacuum chamber of Fig. 1A;
Fig. 3B is a schematic plan view of a second vacuum chamber of Fig. 1A; and
Fig. 4 is a schematic sectional view of a substrate, a mask, and a carrier holding the substrate and mask.

### BEST MODE FOR CARRYING OUT THE INVENTION

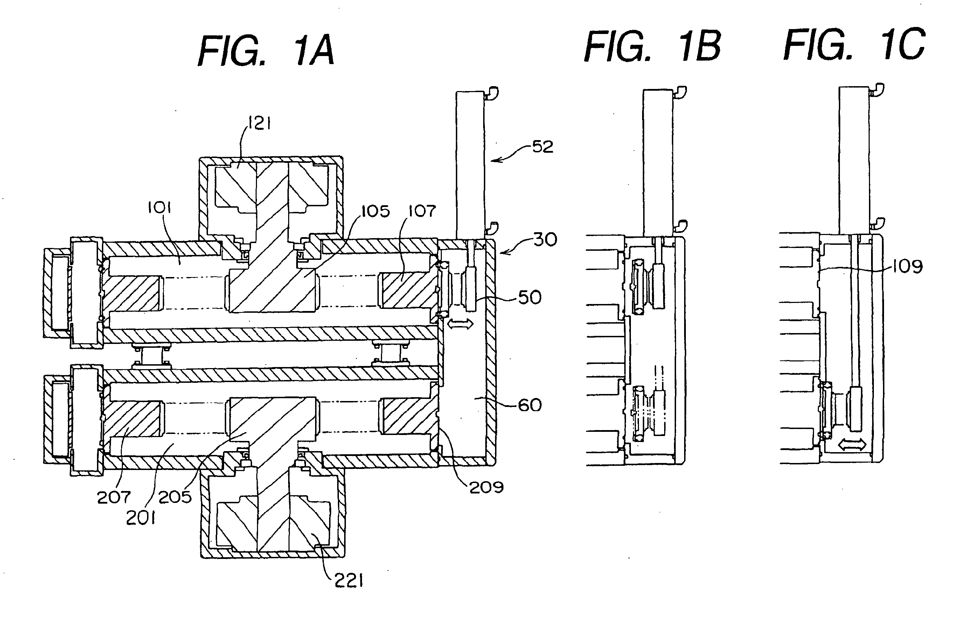

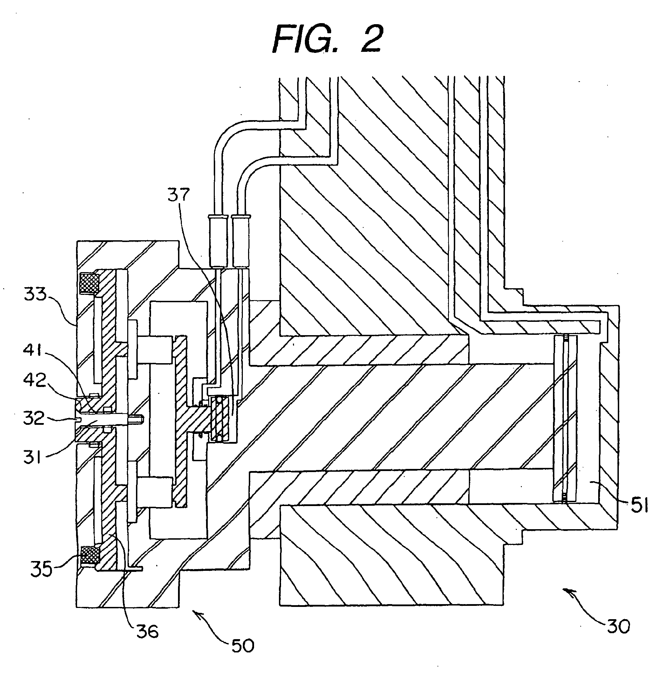

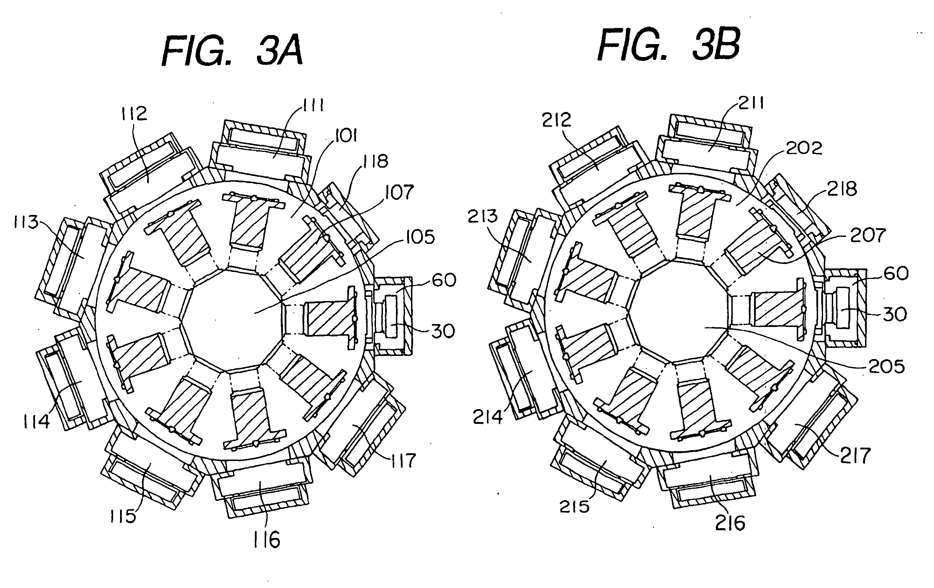

Hereinbelow, a film formation apparatus according to an embodiment of the present invention will be described with reference to the accompanying drawings. Fig. 1A is a longitudinal sectional view of a film formation apparatus according to the present invention, and Figs. 1B and 1C are partial cross-sectional views of the same. Fig. 2 is an enlarged view of a substrate delivery mechanism (portion "A" in the figure) of Fig. 1A. Figs. 3A and 3B are schematic plan views of a first vacuum chamber and second vacuum chamber of Fig. 1A, respectively.

This film formation apparatus is composed of a first vacuum chamber 101 disposed at an upper stage and a second vacuum chamber 201 disposed at a lower stage. The first vacuum chamber 101 provided at the upper stage in the same plane includes a first carrier holder rotating mechanism 105 disposed at the center of the vacuum chamber, plural carrier holders 107 for the first vacuum chamber which are radially connected to the rotating mechanism, a film formation chamber group including a first film formation chamber 111 to a seventh film formation chamber 117, and a substrate feeding chamber 118 on the same plane. The first vacuum chamber is connected to a delivery chamber 60 connected with the second vacuum chamber 201.

The delivery chamber 60 is kept under vacuum like the first vacuum chamber 101 and the second vacuum chamber 102. Also, the carrier holder rotating mechanism 105 is connected to a first motor 121 arranged outside the vacuum chamber and adopted to torque the mechanism. Each carrier holder 107 serves as substrate holding means and constitutes a substrate conveying mechanism together with the carrier holder rotating mechanism 105.

The second vacuum chamber 201 provided at the lower stage in the plane different from the plane as the upper stage includes, similar to the first vacuum chamber 101, a second carrier holder rotating mechanism 205 disposed at the center of the vacuum chamber, plural carrier holders 207 for the second vacuum chamber which are radially connected to the rotating mechanism, a film formation chamber group including an eighth film formation chamber 211 to a fourteenth film formation chamber 217, and a substrate take-out chamber 218. The second vacuum chamber is connected to the delivery chamber 60 connected with the first vacuum chamber. Each carrier holder 207 serves as substrate holding means and constitutes a substrate conveying mechanism together with the carrier holder rotating mechanism 205. Also, the carrier holder rotating mechanism 205 is connected to a second motor 221 provided outside the vacuum chamber and adapted to rotate the mechanism.

Note that the first film formation chamber 111 to the seventh film formation chamber 117 and the eighth film formation chamber 211 to the fourteenth film formation chamber 217 each have an arrangement of various structures such as a structure used for narrowing down a discharge space to a specific region near a target, a so-called earth shield, a structure for preventing sputtered particles from adhering to the interior of the apparatus in excess, a so-called adhesion-preventive shield, an introducing system for an argon gas etc. involved in discharge, a voltage supplying system for applying a voltage to an electrode in order to induce discharge, and an evacuation system. However, those structures are not directly related to the present invention and thus illustration and description thereof are omitted here.

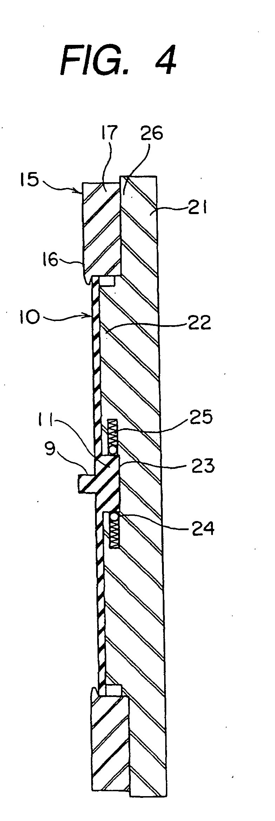

Also, this embodiment is directed to form a thin film on a disk-like substrate having substantially cylindrical protrusions on its front and rear surfaces. Then, it is necessary to secure a non-film-formation region in its outer peripheral portion. Thus, the substrate is held together with a mask for securing the non-film-formation region by a jig called a carrier and conveyed along with the carrier inside this film formation apparatus. Fig. 4 is a schematic cross-sectional view of the carrier, and the substrate and mask that are being held by the carrier.

As shown in Fig. 4, a substantially disk-like substrate 10 has substantially cylindrical protrusions 9 and 11 on its front and rear surfaces, respectively. The carrier 21 has a recess 23 into which the protrusion 11 on the rear surface of the substrate is received, and a ball plunger 24 arranged in a direction perpendicular to the axis of the protrusions and rotated around the axis. When the carrier 21 holds the substrate 10, the protrusion 11 on the rear surface of the substrate is inserted into the recess 23, and fixed and held to the ball plunger 24 as in-holder substrate fixing means.

At this time, the ball plunger 24 is supported by the action of a biasing force of a spring 25 to make the second protrusion 11 and the recess 23 coaxial. The mask 15 includes a ring-shaped mask main body 17 whose inner diameter is larger than an outer diameter of the substrate, and a mask flange 16 for covering the peripheral edge of the substrate 10, which protrudes from its one end face toward the inner peripheral side. A mask receiving portion 26 of the carrier has a magnet (not shown) placed thereon and the mask 15 is fixed and held to the mask receiving portion 26 in close contact therewith by means of a magnetic force produced by the magnet.

The rear surface of the substrate 10 is held to a substantially circular flat surface defined as a substrate receiving portion 22 of the carrier in close contact therewith by the mask 15 coming into close contact with the carrier 21 by means of the magnet. Also, the substrate 10 is heated due to radiation heat etc. from a plasma during the film formation and thermally expands to deform in such a direction as to increase the space between its central portion and the substrate receiving portion 22. The carrier 21 fixes and fits the protrusion 11 on the rear surface into the recess 23 by means of the pressing force from the spring 25 through the ball plunger 24. The deformation is thus suppressed.

The plural carrier holders 107 and 207 arranged in the first vacuum chamber 101 and the second vacuum chamber 201, respectively have magnets (not shown) that exert a magnetic force to carrier receiving surfaces 109 and 209 for holding the carrier, which are defined at their front ends, respectively. The magnetic force allows the mask 15 and the carrier 21 to be held in predetermined positions on the carrier receiving surfaces 109 and 209. The substrate 10 is clamped to the mask 15 and the carrier 21. The mask 15 and the carrier 21 are fixed to the carrier holders 109 and 209, so that the substrate is similarly fixed to the carrier holders 109 and 209. Also, the carrier holders 109 and 209 are connected to the carrier holder rotating mechanisms 105 and 205, respectively at their rear ends.

The carrier holder 107 in the first vacuum chamber 101 is rotated by the first carrier holder rotating mechanism 105 by means of a driving force transmitted from the first motor 121 to the first carrier holder rotating mechanism 105 to thereby move from the substrate feeding chamber 118 to the film formation chambers 111 to 117 and further to the substrate delivery chamber 60. The carrier holder 207 in the second vacuum chamber 201 is rotated by the second carrier holder rotating mechanism 205 by means of a driving force transmitted from the second motor 221 to the second carrier holder rotating mechanism 205 to thereby move from the substrate delivery chamber 60 to the film formation chambers 211 to 217 and further to the substrate take-out chamber 218.

The substrate delivery chamber 60 has, as shown in Fig. 2, a substrate delivery mechanism 30 arranged therein. The substrate delivery mechanism 30 has a head portion 50 that actually holds the substrate 10 etc., a head drive air cylinder 51 for causing the head portion 50 to approach/leave the carrier receiving surfaces 109 and 209 at tip portions of the carrier holders 107 and 207, respectively, and a vertical movement air cylinder 52 for reciprocating the head portion 50 and the head drive air cylinder 51 between the first vacuum chamber 101 and the second vacuum chamber 201. The head portion 50 has a chuck shaft 31 as substrate holding means for clamping the protrusion 9 on the substrate front surface, a magnet 35, a magnet arm 36 connected to the magnet 35 and having a chuck shaft through-hole 41 in which the chuck shaft 31 is inserted, and a magnet air cylinder 37 for driving the magnet arm 36.

The magnet 35 can shift its position between two positions, that is, the closest position to the mask receiving surface 33 and the farthest position from the same by the magnet air cylinder 37 driving the magnet arm. The magnet 35 exerts on the mask 15 the magnetic force stronger than that exerted by the carrier holders 107 and 207 and the carrier 21 on the mask 15, at the closest position to the mask receiving surface 33. As a result, the mask 15 separates from the carrier 21 and is then attracted to the mask receiving surface 33 in the head portion 50. When the magnet 35 is at the farthest position from the mask receiving surface 33, the magnetic force exerted by the magnet 35 on the mask 15 is weaker than that exerted by the magnets in the carrier holders 107 and 207 on the mask 15. Then, the mask 15 is attracted and fixed to the carrier 21 together with the substrate 10.

The chuck shaft 31 has a conical end whose diameter increases toward the end on the mask receiving surface 33 side, and a hole 32 formed in an axial direction, and slits formed around the hole 32 at regular intervals. A taper portion 42 corresponding to the conical end of the chuck shaft 31 is formed at an opening of the chuck shaft through-hole 41 on the mask receiving surface 33 side. The aforementioned chuck shaft end is fitted into the taper portion 42. The magnet air cylinder 37 drives the magnet arm 36 to set the magnet 35 to the closest position to the mask receiving surface 33 and at the same time, the taper portion 42 slides into the conical end of the chuck shaft 31 and then the slits at the tip end of the chuck shaft close to clamp an object inserted into the hole 32.

Next, an apparatus operation in actual film formation steps is described. The substrate 10 and the mask 15 ready for the film formation are transferred to the carrier holder 107 in the substrate feeding chamber 118 by a substrate feeding robot (not shown) while held by the carrier 21 as mentioned above. The carrier holder 107 holds, as discussed above, the mask 15, the carrier 21, and the substrate 10 ready for the film formation which is clamped to those.

In such a state, the carrier holder 107 is rotated by the carrier holder rotating mechanism 105 to transfer the substrate 10 or the like ready for the film formation, to the first film formation chamber 111 adjacent thereto. In practice, each of the film formation chambers 111 to 117 not engaged in the film formation merely forms a recess of the vacuum chamber 101. After being rotated up to the position facing the first film formation chamber 111 and stopped there, the carrier holder 107 is moved toward the first film formation chamber 111 by the carrier holder rotating mechanism 105.

The movement of the carrier holder 107 stops at the time when an outer peripheral portion of the carrier holder contacts with a film formation chamber inner wall 111a. Thus, the substrate 10, the mask 15, and the carrier 21 form the inner wall of the first film formation chamber 111, allowing the thin film formation in the film formation chamber. After the formation of a thin film, the carrier holder rotating mechanism 105 retracts the carrier holder 107, and the carrier holder 107 is ready for rotating again. The thin film is formed with a predetermined thickness on the substrate 10, after which the carrier holder is rotated up to the second film formation chamber 112 adjacent thereto.

The substrate 10 is conveyed from the first film formation chamber 111 to the seventh film formation chamber 117, so that plural thin films are formed thereon. The substrate 10 is thereafter taken over by the head portion 50 of the substrate delivery mechanism 30 in the substrate delivery chamber 60. At this time, the head portion 50 is positioned facing the carrier holder 107 at rest in the delivery chamber 60 of the first vacuum chamber 101 at the upper stage. Driving the head drive air cylinder 51 allows the head portion 50 to approach the carrier holder 107, and when the protrusion 9 on the substrate front surface is fitted into the hole 32 at the tip end of the chuck shaft 31, the approaching movement is suspended, which is based on a sensing signal of a contact sensor (not shown).

Here, the magnet arm 36 of the head portion 50 is moved to the mask receiving surface 33 by the magnet air cylinder 37. The mask 15 is attracted to the magnet 35 and at almost the same time, the chuck shaft 31 clamps the substrate protrusion 9. With those operations, the transfer of the substrate 10 and the mask 15 from the carrier holder 107 to the head portion 50 is completed. Next, the head drive air cylinder 51 makes the head portion 50 apart from the carrier holder 107. The head portion is far enough therefrom and is then moved down to such a position as to allow the carrier holder 207 to face the head portion 50 in the second vacuum chamber 201 at the lower stage.

The downward movement of the head portion 50 is suspended, after which the head drive air cylinder 51 causes the head portion 50 to approach the carrier holder 207 in the second vacuum chamber 201. At this point, the carrier 21 not holding the substrate 10 and the mask 15 is attracted and held to the carrier receiving surface 209 of the carrier holder 207 by means of a magnet (not shown). The head portion stops approaching when the protrusion 11 on the mask rear surface is nearly fitted into the recess 23 of the carrier 21. Suspending the approach is also based on the sensing signal of the contact sensor (not shown). After the approach is suspended, the magnet air cylinder 35 retracts the magnet arm 36 to set the magnet 35 to the farthest position from the mask receiving surface 33 as well as the clamping force of the chuck shaft 31 to the protrusion 9 on the substrate front surface is released.

The carrier holder 207 in the second vacuum chamber 201 has the same structure as the carrier holder 107 in the first vacuum chamber 101. Accordingly, the magnetic force exerted by the head portion 50 on the mask 15 is weakened, whereby the magnetic force of a magnet (not shown) placed on the carrier holder 207 allows the mask 15 and the carrier 21 to clamp the substrate 10 to be attracted and held to the carrier holder 207. With the above operation, the substrate 10 having the predetermined thin film formed thereon in the first vacuum chamber 101 is held by the carrier holder 207 in the second vacuum chamber 201.

After that, the carrier holder 207 is rotated by the second carrier holder rotating mechanism 205 and the substrate 10 is conveyed in the order from the eighth film formation chamber 211 to the fourteenth film formation chamber 217. Hence, predetermined thin films are formed on the substrate. The head portion 50 that has transferred the substrate 10 and the mask 15 to the second carrier holder 207 is driven by each air cylinder and thus spaced from the carrier holder 207 and moved up to a position facing the carrier holder 107 in the first vacuum chamber 101 for receiving the next substrate 10. The movement is suspended at such a position to allow the head portion to receive the next substrate 10. The substrate 10 and the mask 15 after the step of forming the thin film in the fourteenth film formation chamber 217 are conveyed to the substrate take-out chamber 218 where a substrate take-out robot (not shown) transfers them to subsequent steps.

Through the above operation, it is possible to manufacture electronic parts such as DVD-R with a complicated film structure as compared with a film structure attained with the conventional thin film formation apparatus. Also, the number of chambers can be easily increased, making it possible to form a thicker film to the existing film structure. Further, some of the film formation chambers are used as substrate cooling chambers, whereby the substrate can be cooled during the film formation and a product can be offered with less substrate deformation. In addition, feeding and taking-out of the substrate can be effected in separate chambers, which enhances the production efficiency. As compared with the case of increasing only the number of chambers two-dimensionally, the apparatus of the present invention can significantly save an installation space and equipment investment etc. can be suppressed.

Note that in this embodiment, the substrate having the protrusions at the central portions of its front and rear surfaces is used, but the present invention is not limited thereto. The present invention is applicable to various substrates such as a substantially disc-like substrate with a hole formed in a central portion, and a simple, plate-like substrate. Further, the present invention is applicable to the case of forming plural thin films on a predetermined surface of an electronic part and allows such a structure as to hold an electronic part having a specific shape instead of the substrate. Also, the air cylinder drives various components in the substrate delivery mechanism but may be replaced by a known drive mechanism like a stepping motor.

Further, in this embodiment, taken as a specific example is the structure where the seven film formation chambers, the substrate take-out chamber, and the substrate delivery chamber are arranged at the upper stage and the seven film formation chambers, the substrate feeding chamber, and the substrate delivery chamber are arranged at the lower stage. However, the number, structure, and arrangement of film formation chambers, and the number of stages thereof are not limited to those in this embodiment. It is preferable to set them as appropriate according to thin films to be formed. The present invention is also applicable to various film formation apparatuses such as a sputtering apparatus, a CVD apparatus, and an evaporator.

The present invention is thus implemented, whereby the number of chambers in the film formation apparatus can be easily increased. Also, the film formation apparatus saving the installation space and increasing its production efficiency can be provided.

## Claims

1. A thin film formation apparatus for forming a thin film on a surface of a substrate, comprising:
a plurality of vacuum chambers each having a plurality of thin film formation chambers and a conveying system for holding the substrate and conveying the substrate between the thin film formation chambers, the vacuum chambers being arranged in planes different from each other; and
a substrate delivery mechanism for transferring the substrate to the conveying systems between the plurality of vacuum chambers,
**characterized in that** the substrate delivery mechanism is placed in a delivery chamber for communicating the plurality of vacuum chambers with each other.

2. A thin film formation apparatus for forming a thin film on a surface of a substrate, comprising:
thin film formation chambers; a substrate feeding chamber; a substrate delivery chamber, the thin film formation chambers, the substrate feeding chamber, and the substrate delivery chamber being arranged substantially in a circle; and a plurality of substrate holding means arranged almost radially toward each of the chambers and rotatably around a center of a radial pattern, in each of a plurality of planes,
**characterized in that** the substrate delivery chambers each arranged in each of the plurality of planes communicate with each other and the substrate is transferred between the substrate holding means in different planes in the substrate delivery chambers.

3. The thin film formation apparatus according to claim 1 or 2, wherein the substrate is integrated with a mask covering a part of the surface of the substrate and held by the conveying system.

4. The thin film formation apparatus according to claim 1 or 2, further comprising a processing chamber for effecting a process other than thin film formation on the substrate.

5. A thin film formation method for forming a thin film on a substrate, **characterized by** comprising:
feeding and holding the substrate to a conveying system capable of transferring the substrate to a film formation chamber group formed on the same plane;
transferring the substrate to the film formation chamber group arranged on the plane by the conveying system and passing the substrate sequentially through film formation chambers of the film formation chamber group to form the thin film on the substrate;
feeding and holding the substrate to another conveying system capable of transferring the substrate to another film formation chamber group formed on another plane different from the plane through a substrate delivery mechanism provided within a vacuum chamber continuous to the film formation chamber; and
transferring the substrate to the other film formation chamber group arranged on the other plane by the other conveying system and sequentially passing the substrate through film formation chambers of the other film formation chamber group to form another thin film on the substrate.

6. The method according to claim 5, wherein the substrate is integrated with a mask covering a part of the surface of the substrate and held by the conveying system, the other conveying system, and the substrate delivery mechanism.

7. The method according to claim 5, wherein the film formation chamber group and the other film formation chamber group include a processing chamber not involved in film formation and the substrate passes through the processing chamber while being conveyed.

8. An electronic part manufacturing method for forming a thin film on a predetermined surface of an electronic part, **characterized by** comprising:
feeding and holding the electronic part to a conveying system capable of transferring the electronic part to a film formation chamber group formed on the same plane;
transferring the electronic part to the film formation chamber group arranged on the plane by the conveying system and passing the electronic part sequentially through film formation chambers of the film formation chamber group to form the thin film on the predetermined surface of the electronic part;
feeding and holding the electronic part to another conveying system capable of transferring the electronic part to another film formation chamber group formed on another plane different from the plane through an electronic part delivery mechanism provided within a vacuum chamber continuous to the film formation chamber; and
transferring the electronic part to the other film formation chamber group arranged on the other plane by the other conveying system and sequentially passing the electronic part through film formation chambers of the other film formation chamber group to form another thin film on the predetermined surface of the electronic part.

## Amended claims

### Amended claims under Art. 19.1 PCT

1. (Amended) A thin film formation apparatus for forming a thin film on a surface of a substrate, comprising:
a plurality of vacuum chambers each having a plurality of thin film formation chambers and a conveying system for holding a carrier holding the substrate and the substrate and conveying the carrier and the substrate between the thin film formation chambers, the vacuum chambers being arranged in planes different from each other; and
a substrate delivery mechanism for transferring the carrier and the substrate to the conveying systems between the plurality of vacuum chambers,
**characterized in that** the substrate delivery mechanism is placed in a delivery chamber for communicating the plurality of vacuum chambers with each other; the conveying system and the substrate delivery mechanism convey and transfer the substrate together with the carrier; and the plurality of thin film formation chambers each constitute a chamber capable of forming a thin film in cooperation with the substrate, the carrier, and a part of the conveying system.

2. (Amended) A thin film formation apparatus for forming a thin film on a surface of a substrate, comprising:
thin film formation chambers; a substrate feeding chamber; a substrate delivery chamber, the thin film formation chambers, the substrate feeding chamber, and the substrate delivery chamber being arranged substantially in a circle; and a plurality of substrate holding means for holding the substrate together with the carrier holding the substrate, which are arranged almost radially toward each of the chambers and rotatably about a center of a radiation pattern, in each of a plurality of planes, **characterized in that**:
the substrate delivery chambers each arranged in each of the plurality of planes communicate with each other and have a head portion for transferring the substrate between the substrate holding means in different planes in the substrate delivery chamber; and
the thin film formation chambers each constitute a chamber capable of forming a thin film in cooperation with the substrate, the carrier, and the substrate holding means.

3. The thin film formation apparatus according to claim 1 or 2, wherein the substrate is integrated with a mask covering a part of the surface of the substrate and held by the conveying system.

4. The thin film formation apparatus according to claim 1 or 2, further comprising a processing chamber for effecting a process other than thin film formation on the substrate.

5. (Amended) A thin film formation method for forming a thin film on a substrate, **characterized by** comprising:
feeding and holding a carrier holding the substrate and the substrate to a conveying system capable of transferring the carrier and the substrate to a film formation chamber group arranged on the same plane;
transferring the carrier and the substrate to each film formation chamber of the film formation chamber group arranged on the plane by the conveying system, forming a chamber capable of film formation using the film formation chamber, a part of the conveying system, the carrier, and the substrate, and then forming a thin film on the substrate;
feeding and holding the carrier and the substrate to another conveying system capable of transferring the carrier and the substrate to another film formation chamber group arranged on another plane different from the plane, through a substrate delivery mechanism provided inside a vacuum chamber continuous to the film formation chamber; and
transferring the carrier and the substrate to each film formation chamber of the other film formation chamber group arranged on the other plane by the other conveying system, forming another chamber capable of film formation using the film formation chamber, a part of the other conveying system, the carrier, and the substrate, and then forming another thin film on the substrate.

6. The method according to claim 5, wherein the substrate is integrated with a mask covering a part of the surface of the substrate and held by the conveying system, the other conveying system, and the substrate delivery mechanism.

7. The method according to claim 5, wherein the film formation chamber group and the other film formation chamber group include a processing chamber not involved in film formation and the substrate passes through the processing chamber while being conveyed.

8. (Amended) An electronic part manufacturing method for forming a thin film on a predetermined surface of an electronic part, **characterized by** comprising:
feeding and holding a carrier holding the electronic part and the electronic part to a conveying system capable of transferring the carrier and the electronic part to a film formation chamber group arranged on the same plane;
transferring the carrier and the electronic part to each film formation chamber of the film formation chamber group arranged on the plane by the conveying system, forming a chamber capable of film formation using the film formation chamber, a part of the conveying system, the carrier, and the electronic part, and then forming a thin film on the predetermined surface of the electronic part;
feeding and holding the carrier and the electronic part to another conveying system capable of transferring the carrier and the electronic part to another film formation chamber group arranged on another plane different form the plane, through a substrate delivery mechanism provided inside a vacuum chamber continuous to the film forming chamber; and
transferring the carrier and the electronic part to each film formation chamber of the other film formation chamber group arranged on the other plane by the other conveying system, forming a chamber capable of film formation using the film formation chamber, a part of the other conveying system, the carrier, and the electronic part, and then forming another thin film on the predetermined surface of the electronic part.

Statement under Art. 19.1 PCT
Claim 1 relates to a thin film formation apparatus for forming a thin film on a surface of a substrate, comprising: a plurality of vacuum chambers each having a plurality of thin film formation chambers and a conveying system for holding a carrier holding the substrate and the substrate and conveying the carrier and the substrate between the thin film formation chambers, the vacuum chambers being arranged in planes different from each other; and a substrate delivery mechanism for transferring the carrier and the substrate to the conveying systems between the plurality of vacuum chambers, **characterized in that**: the substrate delivery mechanism is placed in a delivery chamber for communicating the plurality of vacuum chambers with each other; the conveying system and the substrate delivery mechanism convey and transfer the substrate together with the carrier; and the plurality of thin film formation chambers each constitute a chamber capable of forming a thin film in cooperation with the substrate, the carrier, and a part of the conveying system. This amendment clarifies that in the thin film formation apparatus of the subject invention, the substrate and the carrier are integrally conveyed, and the thin film formation chamber constitutes a chamber for actually forming a thin film in cooperation with the substrate, the carrier, and a part of the conveying system.

Claim 2 relates to a thin film formation apparatus for forming a thin film on a surface of a substrate, comprising: thin film formation chambers; a substrate feeding chamber; a substrate delivery chamber, the thin film formation chambers, the substrate feeding chamber, and the substrate delivery chamber being arranged substantially in a circle; and a plurality of substrate holding means for holding the substrate together with the carrier holding the substrate, which are arranged almost radially toward each of the chambers and rotatably about a center of a radiation pattern, in each of a plurality of planes, **characterized in that**: the substrate delivery chambers each arranged in each of the plurality of planes communicate with each other and have a head portion for transferring the substrate between the substrate holding means in different planes in the substrate delivery chamber; and the thin film formation chambers each constitute a chamber capable of forming a thin film in cooperation with the substrate, the carrier, and the substrate holding means. This amendment clarifies that in the thin film formation apparatus of the subject invention, the substrate and the carrier are integrally conveyed, the substrate delivery chambers communicate with each other and are used to transfer the carrier and the substrate to the substrate holding means, and the thin film formation chamber constitutes a chamber for actually forming a thin film in cooperation with the substrate, the carrier, and a part of the conveying system.

Claim 5 relates to a thin film formation method for forming a thin film on a substrate, **characterized by** comprising: feeding and holding a carrier holding the substrate and the substrate to a conveying system capable of transferring the carrier and the substrate to a film formation chamber group arranged on the same plane; transferring the carrier and the substrate to each film formation chamber of the film formation chamber group arranged on the plane by the conveying system, forming a chamber capable of film formation using the film formation chamber, a part of the conveying system, the carrier, and the substrate, and then forming a thin film on the substrate; feeding and holding the carrier and the substrate to another conveying system capable of transferring the carrier and the substrate to another film formation chamber group arranged on another plane different from the plane, through a substrate delivery mechanism provided inside a vacuum chamber continuous to the film formation chamber; and transferring the carrier and the substrate to each film formation chamber of the other film formation chamber group arranged on the other plane by the other conveying system, forming another chamber capable of film formation using the film formation chamber, a part of the other conveying system, the carrier, and the substrate, then forming another thin film on the substrate. This amendment clarifies that with the thin film formation method of the subject invention, the substrate and the carrier can be integrally conveyed, and the thin film formation chamber constitutes a chamber for actually forming a thin film in cooperation with the substrate, the carrier, and a part of the conveying system.

Claim 8 relates to an electronic part manufacturing method for forming a thin film on a predetermined surface of an electronic part, **characterized by** comprising: feeding and holding a carrier holding the electronic part and the electronic part to a conveying system capable of transferring the carrier and the electronic part to a film formation chamber group arranged on the same plane; transferring the carrier and the electronic part to each film formation chamber of the film formation chamber group arranged on the plane by the conveying system, forming a chamber capable of film formation using the film formation chamber, a part of the conveying system, the carrier, and the electronic part, and then forming a thin film on the predetermined surface of the electronic part; feeding and holding the carrier and the electronic part to another conveying system capable of transferring the carrier and the electronic part to another film formation chamber group arranged on another plane different form the plane, through a substrate delivery mechanism provided inside a vacuum chamber continuous to the film forming chamber; and transferring the carrier and the electronic part to each film formation chamber of the other film formation chamber group arranged on the other plane by the other conveying system, forming a chamber capable of film formation using the film formation chamber, a part of the other conveying system, the carrier, and the electronic part, and then forming another thin film on the predetermined surface of the electronic part. This amendment clarifies that with the electronic part manufacturing method of the subject invention, the electronic part and the carrier are integrally conveyed, and the thin film formation chamber constitutes a chamber for actually forming a thin film in cooperation with the electronic part, the carrier, and a part of the conveying system.

The prior art documents that would give grounds for negating the novelty and inventive step of the subject invention include (1) US 6066210, (2) JP 08-162514 A, (3) JP 03-274746 A, and (4) JP 11-40643 A, as Cited Documents 1 to 4, respectively.

Cited Documents 1 and 3 disclose a processing apparatus for a semiconductor wafer and Cited Documents 2 and 4 disclose a processing apparatus for a semiconductor wafer and a processing apparatus for a glass substrate. The disclosed contents involve an object to reduce an installation space and a solution thereto, that is, a structure of a multi-stage processing chamber.

The processing chambers disclosed in those cited documents define individual confined spaces independently of each other, and a substrate such as a semiconductor wafer is carried into the confined space and subjected to various processings there. Accordingly, the conveying system in the apparatus disclosed in each cited document only conveys the substrate alone. In contrast, the apparatus according to the application concerned allows a substrate (part) to undergo various processes only after the substrate (part) and a carrier holding the substrate are integrally conveyed to partially constitute the wall of the thin film formation chamber etc. In other words, the apparatus disclosed in each cited document is the same as the apparatus according to the application concerned in that a vacuum atmosphere is adopted but largely differs therefrom in an actual apparatus structure such as the form of the apparatus in the actual case of subjecting the substrate etc. to any process.

Accordingly, those cited documents do not disclose at all the structure specific to the invention of the application concerned, which is defined in claims 1, 2, 5, and 8 of the application concerned, that is, the structure that "allows a substrate (part) to undergo various processes only after the substrate (part) and a carrier holding the substrate are integrally conveyed to partially constitute the wall of the thin film formation chamber etc." Also, even if the substrate delivery between the vacuum chambers arranged in different planes is carried out on the basis of the disclosed contents of each cited document, the structure that could be most easily arrived at would be merely the form of conveying the substrate solely. The structure specific to the application concerned would be deemed as essential in keeping the substrate rear surface in close contact with the carrier surface as described in lines 1-6 on page 8 of the specification. Therefore, we believe that the invention according to the foregoing claims could not be easily arrived at on the basis of each cited document.

We also believe that the invention according to claims 3, 4, 6, and 7 could not be easily arrived at on the basis of each cited document since the inventions according to independent claims 1, 2, and 5 therefor cannot be suggested from the foregoing respective cited documents, and those dependent claims involve addition of new matters.
